# EUROPEAN PATENT APPLICATION

(11) **EP 0 657 815 A1**
(43) Date of publication of application: **14.06.1995**
(21) Application number: 94116801.5
(22) Date of filing: 25.10.1994
(51) Int. Cl.: G06F 11/22, G01R 31/3167

(54) **Boundary scan test system and method for testing a circuit network having analog and digital devices**

(30) Priority: 10.12.1993 US 165775
(71) Applicant: International Business Machines Corporation, Armonk, N.Y. 10504 (US)
(72) Inventor: Heybruck, William Francis, Charlotte, NC 28227 (US); Stewart, Bret Allen, Harrisburg, NC 28075 (US)
(74) Representative: Schäfer, Wolfgang, Dipl.-Ing.

(57) **Abstract**

Disclosed is a method and system for boundary scan testing of a multi-element circuit network having analog and digital devices.

## Description

### FIELD OF THE INVENTION

The invention relates to boundary scan testing of electronic circuit networks having both individual digital integrated circuit chips and individual analog integrated circuit chips which are not testable by the digital testing methods. Modern boundary scan testing technology consists of digital testing techniques, such as the IEEE 1149.1 Standard boundary scan testing and Level Sensitive Scan Design testing, as well as other methodologies, especially those developed for analog devices. Generating test patterns for both types of boundary scan testing, that is, analog boundary scan testing and digital boundary scan testing, as when both types of integrated circuit chips are present in the same circuit network, that is, on the same printed circuit board or card, has heretofore been accomplished only through special custom test circuits, test fixtures, and test programming. According to the system and method of the invention described herein, commonly available hardware and software can be used to automatically test circuit networks with mixed digital and analog integrated circuit types.

### BACKGROUND OF THE INVENTION

### Boundary Scan Testing

Boundary scan testing is described in many papers, including R.W. Bassett, M.E. Turner, J. H. Panner, P.S. Gillis, S.F. Oakland, and D.W. Stout, "Boundary Scan Design Principles for Efficient LSSD ASIC Testing," IBM Journal of Research and Development, Vol. 34, No. 2/3, March/May 1990, pp. 339-354.

Heretofore functional testing of printed circuit boards has been carried out by test fixtures that facilitated "bed of nails" contact of the individual integrated circuit leads. The development of high pin count devices and surface mount technology, with high populations of high I/O density, grid array components, frequently on both sides of a card or board, has made bed of nails testing prohibitively expensive. To allow bed of nails testing, surface mount packages must either sacrifice their high I/O advantage and chip density, or even more complex and costly testing fixtures must be used.

Boundary scan testing provides an alternative to bed of nails testing. Boundary scan testing provides board signal node access while limiting in-circuit test fixturing. Boundary scan techniques replace the physical access points needed for in-circuit testing with equivalent logical access points. These equivalent logical access points are the boundary scan latches. The boundary scan latches correspond to the signal I/O pins of each component.

The board testing applications of boundary scan methodology have led to development of many boundary scan testing technologies, including Level Sensitive Scan Design devices and IEEE 1149.1 Standard devices.

### IEEE 1149.1 Standard Boundary Testing

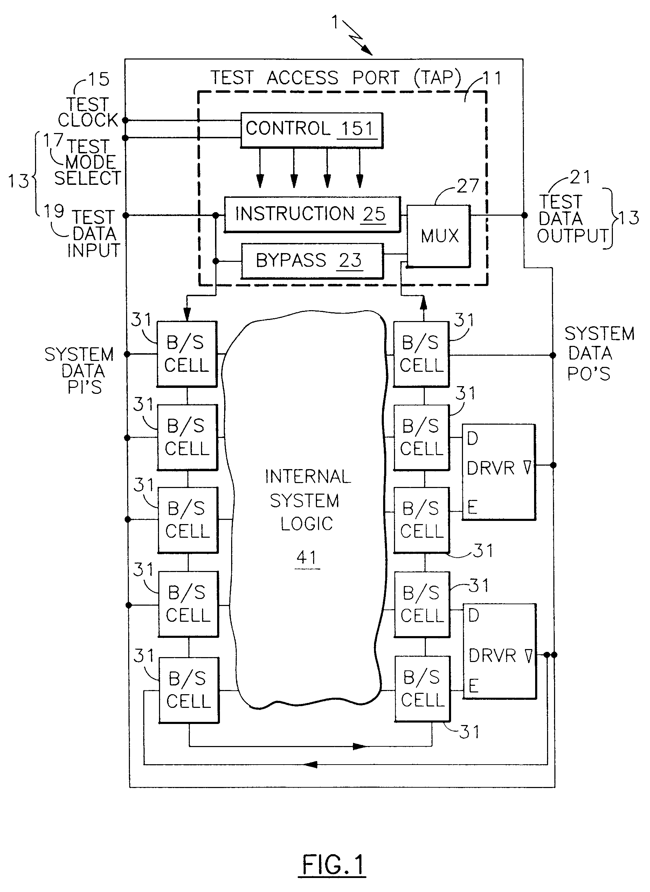

The IEEE 1149.1 standard for digital integrated circuit networks requires a chip architecture of the type illustrated in FIGURE 1 where each conforming chip has a standard Test Access Port (TAP) **11** designed and incorporated as an internal component thereof. This integral Test Access Port is operated by means of a four pin test signal interface **13**. The signal pins of the Test Access Port **11** comprise a Test Clock (TCK) **15**, a Test Mode Select (TMS) **17**, a serial Test Data Input (TDI) **19**, and a serial Test Data Output (TDO) **21**.

The basic elements of the IEEE 1149.1 Standard architecture are illustrated in FIGURES 1 through 6. FIGURE 1 shows a schematic overview of an IEEE 1149.1 Standard integrated circuit chip **1**, with peripheral boundary scan cells **31**, internal system logic **41**, and the Test Access Port **11**, with the TCK **15** and TMS **17** inputs to the test access port **11**, the TDI input **19** to the Instruction **25** and Bypass **23** Registers, the multiplexer **27**, and the TDO output **21** from the test access port **11**.

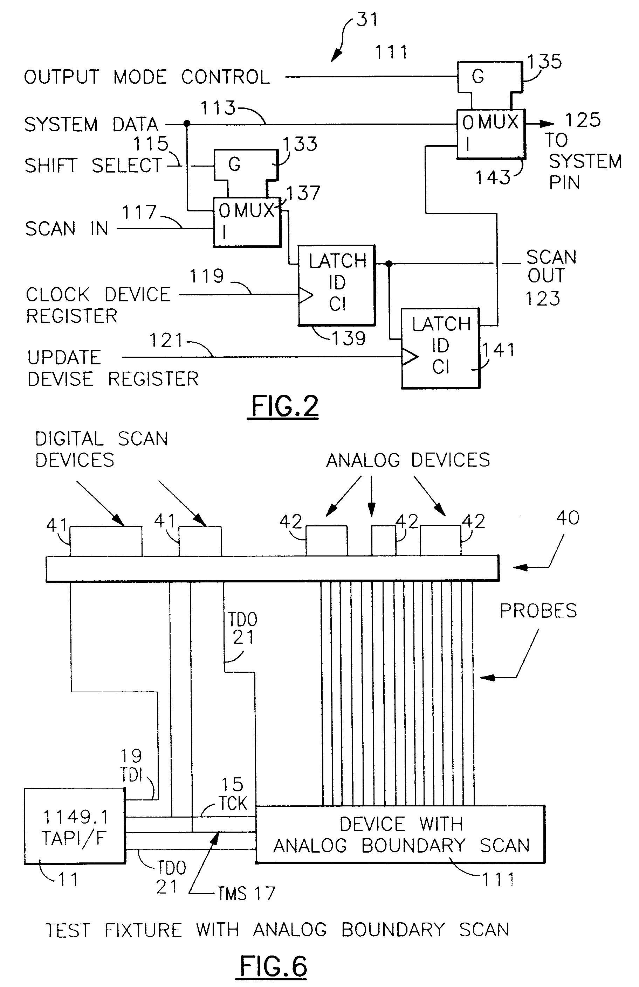

FIGURE 2 shows an individual IEEE 1149.1 Standard Boundary Scan Cell **31**. The boundary scan cell **31** includes an output mode control **111**, system data input **113**, shift select **115**, and scan data in **117**, as well as a clock driver **119**, an update driver **121**, a scan data out **123**, and a system pin out **125**. The individual boundary scan cell **31** includes gates **133** and **135**, that are part of multiplexers **137**, **141**, and **143**. Also present in the boundary scan cell **131** are latches **139** and **141**.

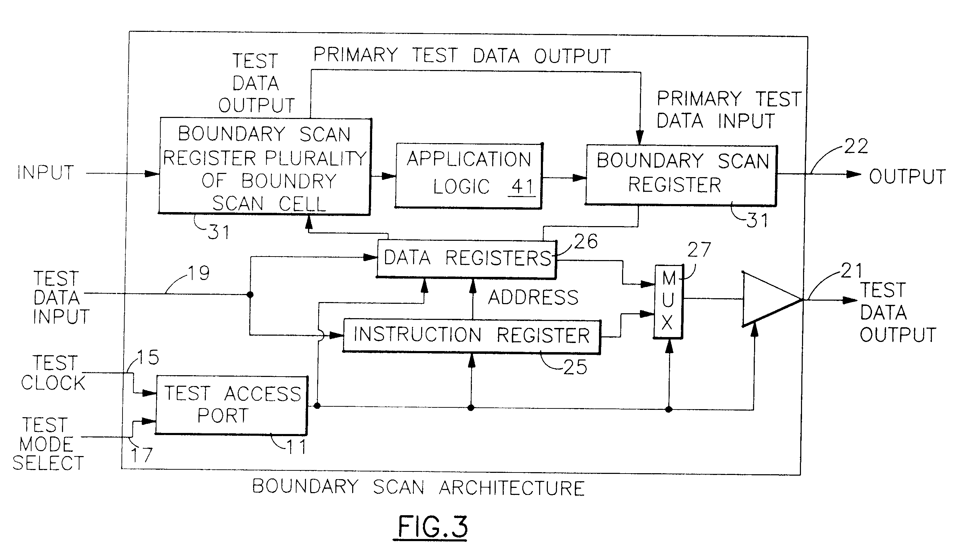

FIGURE 3 shows the registers as instruction register **25** and data register **26**. The system output **22** is also shown. FIGURE 3 shows the IEEE 1149.1 Standard boundary scan architecture and logic flow between the registers **25**, **26**, and the internal system **41** logic.

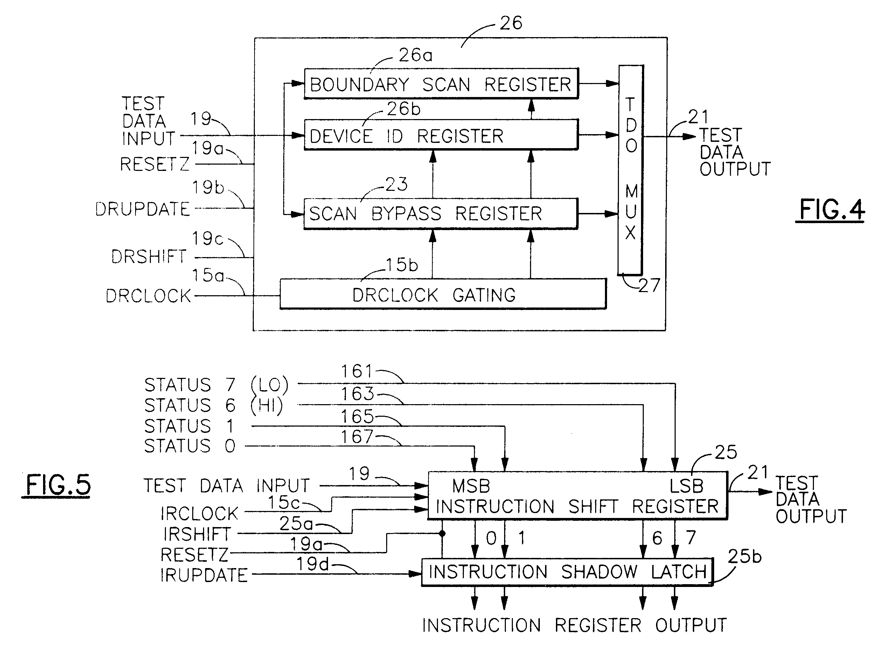

FIGURE 4 shows all of the IEEE 1149.1 Standard Data Registers, including the boundary scan register **26a**, the device identification register **26b**, the scan bypass register **26c**, and the clock driver **12** and clock gating **15b**. Also shown are the Control, Reset **19a**, and the drivers **19b** and **19c**.

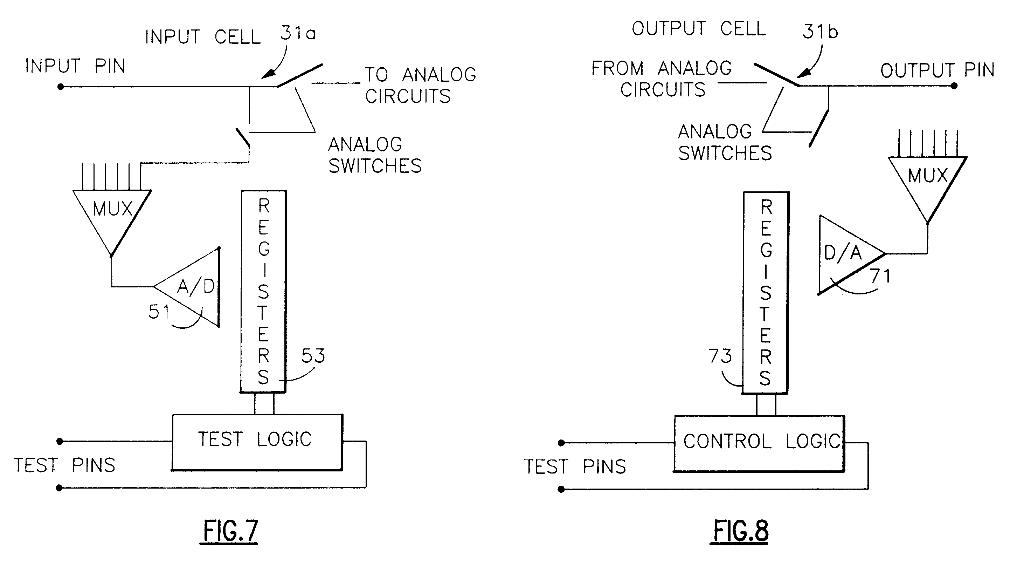

FIGURE 5 shows the Instruction Register inputs and outputs. These includes the individual status bits **161**, **163**, **165**, **167**, the TDI **19**, the instruction register clock **15c**, the instruction register shift **25a**, resetz **19a**, and the instruction register update **19d**. The instruction register 25 has an instruction shadow latch **25b**.

The Test Access Port is controlled by an internal, synchronous, finite state machine with sixteen states. The Test Access Port's bahavior is controlled by the values placed on the TMS input at the time of a rising edge transition on the TCK signal. The state machine can be initialized to a known reset state within five clock signals.

The Test Access Port contains a serially loadable instruction register and a one bit scan bypass register.

According to the IEEE 1149.1 Standard all component signal I/O pins, other than test signal interface pins, must be directly connected to logically adjacent boundary scan cells. The boundary scan cells must be interconnected to form a single boundary scan shift register operated under Test Access Port control.

Under the IEEE 1149.1 Standard there are three mandatory instructions which must be supported: BYPASS, EXTEST, and SAMPLE. BYPASS permits board level shift register reconfiguration. This allows more efficient scanning by using the Bypass Register to bypass a module's boundary scan register when the module does not need to be included in a certain test. EXTEST permits test of board level interconnection wiring using the boundary scan register. SAMPLE permits monitoring of signals entering and leaving a component during normal system operation using the boundary scan register.

Testers with analog capability are required to test circuit boards populated with either (a) analog circuits, or (b) mixed analog and digital circuits. Moreover, the self test of analog or mixed analog-digital circuits requires specialized test circuitry. The specialized test circuitry can be analog, digital, or mixed analog-digital. One problem is that the test circuitry may be difficult to test. Incorporating a method of analog boundary scan permits the control of analog signals directly, where needed, at required tolerances, and the observation of analog signals via the analog boundary scan cells. In self-test, analog boundary cells can be used to generate the diagnostic information.

### OBJECTS OF THE INVENTION

It is a primary object of the invention to provide a method of boundary scan testing a card or board containing both analog and digital devices in a single testing operation.

It is a further object of the invention to provide a boundary scan system for testing a card or board containing both digital and analog devices in a single testing operation.

### SUMMARY OF THE INVENTION

These and other objects are attained by the boundary scan testing method and apparatus of our invention. According to our invention there is provided a system, optionally including a fixture and an integrated circuit, that allows the testing of a circuit network **40**, for example, a populated printed circuit card or board, having digital integrated circuits **41**, for example, testable by the IEEE 1149.1 Standard boundary testing or by Level Sensitive Scan Design testing, or the like, and analog integrated circuits **42** not heretofore testable by digital testing methods, such as IEEE 1149.1 Standard boundary testing or Level Sensitive Scan Design boundary testing.

The test system of the invention, optionally including the test fixture and the test circuitry is useful for boundary scan testing a circuit network **40** characterized by functionally and logically dissimilar integrated circuits therein. That is, the circuit under test has at least one first integrated circuit that is a digital integrated circuit **41**, and at least one second integrated circuit that is an analog integrated circuit **42**. The second integrated circuit **42** is one requiring an analog input or providing an analog output.

Panel testing is carried out in a testing fixture. Either the testing fixture, or the circuit network under test, or the individual integrated circuit chips **41**, **42** have an integrated circuit chip including a Test Access Port interface **11**. The Test Access Port interface **11** implements the boundary scan testing logic.

The system includes boundary scan means for applying a digital test input signal to the multi-element circuit network **40** under test and recovering a digital test output signal from the multi-element circuit network **40** under test. The individual circuit elements **41**, **42** are joined by shift register elements for moving the digital test signal from a circuit network element to a sequential circuit element in the multi-element circuit network **40** under test. There are also shift register elements at inputs of an analog circuit element **42** under test. These shift register elements are used for receiving the digital test signal from the preceding circuit. An analog to digital convertor **51** is in parallel with the shift register for converting the analog test signal to a digital signal. The test signal is applied to the analog circuit element **42** under test. There is also a digital to analog converter **71** at the output leads of the analog circuit element **42** under test. This D/A converter is to convert the digital signal to an analog signal. A shift register is provided in parallel with the digital to analog convertor to transfer the test signal to a subsequent element, such as a digital integrated circuit chip **41**.

The invention also includes a method for testing a multi-element circuit network **40** having boundary scan testing means, and analog **42** and digital **41** circuit elements. This method includes the step of applying a digital test input signal through the boundary scan test means to the multi-element circuit network **40** under test. This is followed by moving the digital test signal from a circuit network element to a sequential circuit element, for example through shift register means. The shifted digital input is received at output cells of an analog circuit element under test. A digital signal is converted to an analog signal in a digital to analog convertor **71**, and the analog test signal is driven from one analog circuit element 42 to the card and to another circuit element **42**. After passing into the second analog circuit element **42** the input signal of the analog circuit is converted at an analog to digital **51**. This test signal is transferred to a subsequent element, for example a digital element **41**. After passing through the elements of the network **40** the digital test signal is recovered, through the boundary scan means, from the multi-element circuit network **40** under test.

### THE FIGURES

The invention may be understood by the reference to the FIGURES appended hereto.

FIGURE 1 shows a schematic overview of an IEEE 1149.1 Standard integrated circuit chip, with peripheral boundary scan cells, internal system logic, and the Test Access Port, with its inputs and outputs.

FIGURE 2 shows an individual IEEE 1149.1 Standard Boundary Scan Cell.

FIGURE 3 shows the IEEE 1149.1 Standard boundary scan architecture and logic flow.

FIGURE 4 shows an IEEE 1149.1 Standard Data Register.

FIGURE 5 shows the IEEE 1149.1 Instruction Register outputs.

FIGURE 6 shows a schematic view of a test fixture of the invention with a digital device and an analog device in position for testing.

FIGURE 7 shows an input cell of an analog integrated circuit, with an analog to digital (A/D) convertor.

FIGURE 8 shows an output cell an analog integrated circuit, with a digital to analog (D/A) convertor.

FIGURE 9 shows a test cell with a combined input/output lead that drives both on-chip and off-chip signals.

FIGURE 10 shows the combination of an analog circuit and its associated boundary cells.

### DETAILED DESCRIPTION OF THE INVENTION

According to our invention there is provided a method and a system for testing the interconnections of networks **40** of digital **41** and analog **42** integrated circuit chips on a printed circuit board or card. In the method and system described herein, the analog inputs to an analog circuit element under test are converted to digital signals and shifted, and the shifted digital signal is converted to an analog signal in a digital to analog convertor **71**. The system tests the interconnections, and not necessarily the individual circuit elements. The system, optionally including a fixture and an integrated circuit, allows the testing of mixed digital **41** and analog **42** circuit networks **40**. A circuit network **40** is a populated printed circuit card or board, having integrated circuits, that is, digital integrated circuits **41** such as those testable by the IEEE 1149.1 Standard boundary testing or level sensitive scan design testing, among others, and analog integrated circuits **42**, not heretofore testable by digital boundary scan testing methods and systems.

At the present time software exists to generate infrastructure tests and interconnect tests between electronic devices, for example, digital integrated circuit chips **41**, utilizing such boundary scan testing techniques as those embodied in the IEEE 1149.1 Standard. Software also exists to automatically generate tests between digital devices utilizing other standards. However, there has heretofore been no software or hardware that will automatically generate and perform interconnect tests between mixed function devices in a multi-device network **40**, such as digital integrated circuit chips **41** and analog integrated circuit chips **42** in the same network **40**. This requires the use of different and heretofore incompatible types of boundary scan standards, fixtures, testers, and software.

Utilizing the method and apparatus described herein, circuit networks, that is, populated electronic circuit cards, incorporating both analog **42** and digital **41** devices can have interconnect tests generated quickly and efficiently.

A test fixture that is useful in the practice of the invention is shown generally in FIGURE 6. It should be noted that the Test Access Port (TAP) **11** can be built into the chips under test, a separate chip on the card or board under test, or can be part of a test fixture, without departing from the idea of the invention described herein. Where a test fixture is used, the fixture can impose a test access port interface between the fixture and the internal logic of the integrated circuit chips under test. The TAP circuitry contains a state machine **151** as well as a set of registers, the Instruction Register **25**, the Data Register **26**, and the Bypass Register **23**. This circuit may be built according to the IEEE 1149.1 Standard, as described hereinabove.

The test system of the invention, optionally including the test fixture and the test circuitry is useful for boundary scan testing a circuit network **40** characterized by having both analog **42** and digital **41** integrated circuits therein. That is, the circuit network **40** under test has at least one first integrated circuit that is a digital integrated circuit **41** of the type testable by IEEE 1149.1 Standard boundary testing or Level Sensitive Scan Design testing, or the like, and at least one second integrated circuit that is an analog integrated circuit **42**, for example an operational amplifier circuit or network.

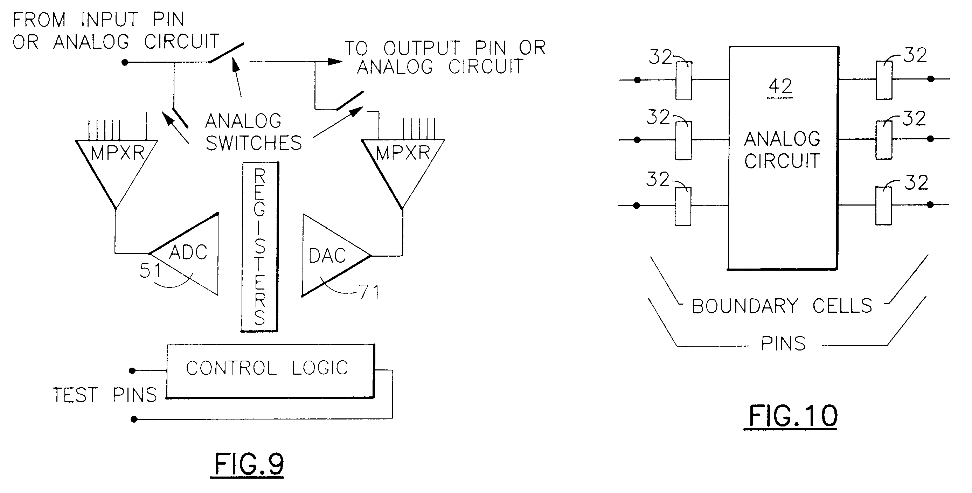

As shown in FIGURES 7 and 8, the test system includes boundary scan test means for applying a digital test input signal to the multi-element circuit network **40** under test and recovering a digital test output signal from the multi-element circuit network **40** under test. The individual circuit elements are joined by shift register elements for moving the digital test signal from a circuit network element to a sequential circuit element in the multi-element circuit network **40** under test. There are also shift register elements **53** at inputs of the analog circuit elements **42** under test. For analog integrated circuit chips **42** whose interconnections are under test it is necessary to capture the digital representations of the analog input test signals. An analog to digital convertor (A/D) **51** is provided in parallel with the shift register **53** for converting the applied analog test signal to a digital test signal. There is also a digital to analog (D/A) converter **71** at the output leads of the analog circuit element **42** under test. This Digital to Analog (D/A) convertor **71** is used to convert the digital test signal to an analog test signal. A shift register **73** is provided in parallel with the Digital to Analog converter **71** to transfer the digitized test signal from a previous element in the scan chain, such as a digital integrated circuit chip.

As shown in FIGURE 9, the invention also includes a method and apparatus for testing a multi-element circuit network **40** having boundary scan testing means, and analog **42** and digital **41** circuit elements. This method includes the step of applying a digital test input signal through the boundary scan test means to the multi-element circuit network **40** under test. This is followed by moving the digital test signal from a circuit network element to a sequential circuit element, for example through shift register means. The shifted digital input is received at inputs of an analog circuit element **42** under test. This is illustrated in FIGURE 9. The digital signal is converted to an analog signal in a digital to analog convertor **71**, and the analog test signal is applied to the analog circuit element under test. After passing through the analog circuit element **42** the output signal of the analog circuit is digitized at an analog to digital converter **51**. This digitized test signal is transferred to a subsequent element, for example a digital element. After passing through the elements of the network the digital test signal is recovered, through the boundary scan means, from the multi-element circuit network under test.

The method and apparatus of the invention utilizes analog boundary scan cells **32**, as shown with specificity in FIGURE 10. Analog boundary scan cells are placed at the inputs and outputs of the analog integrated circuit **42** under test. Alternatively, or additionally, they can be placed within the analog circuitry **42** to test the individual device or circuit.

The boundary cell circuits **32** are placed at each input pin and at each output pin. For analog circuit cards the boundary cells can be fabricated as independent components and placed at the card I/O, providing card level boundary scan testing.

There are input boundary cells **31a** and output boundary cells **31b**. An input cell **31a** consists of an Analog to Digital (A/D) converter **51**. The A/D converter is strobed and sensed through a digital controller via the test system, for example, the test fixture. At the appropriate time a digital signal triggers the A/D converter **51** to generate a digital representation of the sensed analog signal. This digital representation is stored in a latch or set of latches. The latched value is scanned out at a later time for processing by the fixture.

An output cell **32b** consists of an Digital to Analog (D/A) converter **71**. The Digital to Analog convertor **71** converts a preloaded digital value to an analog signal which drives the output pin of the device.

The input circuits are connected to the output circuits through a matrix of analog switches. This allows self-calibration of each boundary cell circuit prior to testing the device.

Thus, using the method and system of the invention it is possible to use a single test fixture for testing a card or board containing both analog and digital devices in a single testing operation. According to a further embodiment of our invention there is now provided a method of testing a card or board containing both analog and digital devices in a single testing operation.

While the invention has been described with respect to certain preferred embodiments and exemplifications, it is not intended to limit the scope of the invention thereby, but solely by the claims appended hereto.

## Claims

1. A testing system for testing a multi-element circuit network having analog and digital circuit elements, said testing system comprising:
a. boundary scan means for applying a digital test input signal to the multi-element circuit network under test and recovering a digital test output signal from the multi-element circuit network under test;
b. shift register means for moving the digital test signal from a circuit network element to a sequential circuit element in the multi-element circuit network under test;
c. shift register means at inputs of an analog circuit element under test for receiving the digital test signal, analog to digital convertor means in parallel therewith for converting the analog test signal to a digital signal, and shift register means for transferring the digital signal to a subsequent element; and
d. digital to analog converter means at output leads of the analog circuit element under test for converting the test signal to an analog signal, and applying the analog test signal to the analog circuit element under test.

2. A method for testing a multi-element circuit network having boundary scan testing means, and analog and digital circuit elements, said method comprising:
a. applying a digital test input signal through the boundary scan test means to the multi-element circuit network under test;
b. moving the digital test signal from a circuit network element to a sequential circuit element;
c. receiving the digital test signal at inputs of an analog circuit element under test, converting an analog signal to a digital signal in analog to digital convertor means, and transferring a test signal to a subsequent element;
d. converting the output signal of the analog element at digital to analog converter means, and applying a test signal to the analog circuit element under test; and
e. recovering a digital test output signal through the boundary scan means from the multi-element circuit network under test.

3. A method for testing a multi-element circuit network having boundary scan testing means, and analog and digital circuit elements, said method comprising:
a. applying a digital test input signal through the boundary scan test means to the multi-element circuit network under test;
b. moving the digital test signal from a circuit network element to a sequential circuit element through shift register means in the multi-element circuit network under test;
c. receiving the digital test signal in shift register means at inputs of an analog circuit element under test, converting an analog signal to a digital signal in analog to digital convertor means in parallel therewith, and transferring digital test signal to a subsequent element through shift register means;
d. converting an output signal of the analog element at digital to analog converter means associated with output leads of the analog circuit element under test, and applying the test signal to the analog circuit element under test; and
e. recovering a digital test output signal from the multi-element circuit network under test.
